# EUROPEAN PATENT APPLICATION

(11) **EP 4 258 329 A1**
(43) Date of publication of application: **11.10.2023**
(21) Application number: 23164129.1
(22) Date of filing: 24.03.2023
(51) Int. Cl.: H01L 21/67

(54) **SUBSTRATE PROCESSING APPARATUS, METHOD OF MANUFACTURING SEMICONDUCTOR DEVICE AND PROGRAM**

(30) Priority: 24.03.2022 JP 2022049018; 26.01.2023 JP 2023010521
(71) Applicant: Kokusai Electric Corp., Tokyo 1010045 (JP)
(72) Inventor: YAMAMOTO, Katsuhiko, Toyama-shi, 939-2393 (JP); SAIDO, Shuhei, Toyama-shi, 939-2393 (JP); NAKAGAWA, Takashi, Toyama-shi, 939-2393 (JP); YANAGISAWA, Yoshihiko, Toyama-shi, 939-2393 (JP); SASAKI, Shinya, Toyama-shi, 939-2393 (JP); MICHITA, Noriaki, Toyama-shi, 939-2393 (JP)
(74) Representative: Verscht, Thomas Kurt Albert

(57) **Abstract**

According to the present disclosure, there is provided a technique capable of preventing a substrate from being warped or cracked due to a heat treatment process. According to one aspect thereof, there is provided a substrate processing apparatus including: a process chamber in which a plurality of substrates accommodated in a substrate retainer are processed; an electromagnetic wave generator configured to supply an electromagnetic wave into the process chamber; and a gas supplier configured to supply a cooling gas is supplied to between adjacent substrates among the plurality of substrates via a plurality of gas supply ports provided so as to correspond to an interval of the plurality of substrates accommodated in the substrate retainer.

## Description

### [Technical Field]

The present disclosure relates to a substrate processing apparatus, a method of manufacturing a semiconductor device and a program.

### [Related Art]

As a part of a manufacturing process of a semiconductor device, a modification process such as an annealing process may be performed. For example, the annealing process is performed by heating a substrate in a process chamber by using a heater to change a composition or a crystal structure of a film formed on a surface of the substrate or to restore a defect such as a crystal defect in the film. Recently, the semiconductor device is integrated at a high density and remarkably miniaturized. As a result, it is preferable that the modification process is performed to obtain a high density substrate on which a pattern is formed with a high aspect ratio. As the modification process capable of modifying the high density substrate, a heat treatment process using an electromagnetic wave may be performed according to Patent Document 1, for example.

### [Related Art Document]

### [Patent Document]

Patent Document 1: Japanese Patent Laid-Open No. 2015-070045

### [Disclosure]

### [Technical Problem]

However, in the heat treatment process using the electromagnetic wave, the substrate may warp or crack due to a non-uniformity of a temperature on the surface of the substrate such as a semiconductor substrate when the heat treatment process is performed.

According to the present disclosure, there is provided a technique capable of preventing a substrate from being warped or cracked due to a heat treatment process.

### [Technical Solution]

According to an aspect the technique of the present disclosure, there is provided a substrate processing apparatus including: a process chamber in which a plurality of substrates accommodated in a substrate retainer are processed; an electromagnetic wave generator configured to supply an electromagnetic wave into the process chamber; and a gas supplier configured to supply a cooling gas is supplied to between adjacent substrates among the plurality of substrates via a plurality of gas supply ports provided so as to correspond to an interval of the plurality of substrates accommodated in the substrate retainer.

### [Advantageous Effects]

According to some embodiments of the present disclosure, it is possible to prevent a substrate from being warped or cracked due to a heat treatment process.

### [Brief Description of Drawings]

FIG. 1 is a diagram schematically illustrating a vertical cross-section of a process furnace of a substrate processing apparatus preferably used in one or more embodiments of the present disclosure.
FIG. 2 is a diagram schematically illustrating a vertical cross-section of the substrate processing apparatus including the process furnace preferably used in the embodiments of the present disclosure.
FIG. 3 is a diagram schematically illustrating a horizontal cross-section of the substrate processing apparatus preferably used in the embodiments of the present disclosure.
FIG. 4 is a block diagram schematically illustrating a configuration of a controller and related components of the substrate processing apparatus preferably used in the embodiments of the present disclosure.
FIG. 5 is a diagram for explaining a heat build-up in the substrate processing apparatus preferably used in the embodiments of the present disclosure.
FIG. 6 is a diagram for explaining exemplary conditions of a nozzle (for example, an interval between adjacent holes, the number of the holes and a diameter of each hole) provided in the substrate processing apparatus preferably used in the embodiments of the present disclosure.
FIG. 7 is a diagram schematically illustrating a result of a change in an ejection direction of the nozzle provided in the substrate processing apparatus preferably used in the embodiments of the present disclosure.
FIG. 8A is a diagram for explaining an example in which a plurality of nozzles are provided in the substrate processing apparatus preferably used in the embodiments of the present disclosure.
FIG. 8B is a diagram schematically illustrating a control of an ejection directed to a hot spot for the nozzle provided in the substrate processing apparatus preferably used in the embodiments of the present disclosure.
FIG. 9 is a flow chart schematically illustrating an exemplary flow of a substrate processing preferably used in the embodiments of the present disclosure.
FIG. 10 is a diagram schematically illustrating an example in which a thermal imaging camera is attached to the substrate processing apparatus preferably used in one or more embodiments of the present disclosure.
FIG. 11 is a diagram schematically illustrating an example of simulation results of the substrate processing apparatus preferably used in one or more embodiments of the present disclosure.

### [Detailed Description]

### <Embodiments of Present Disclosure>

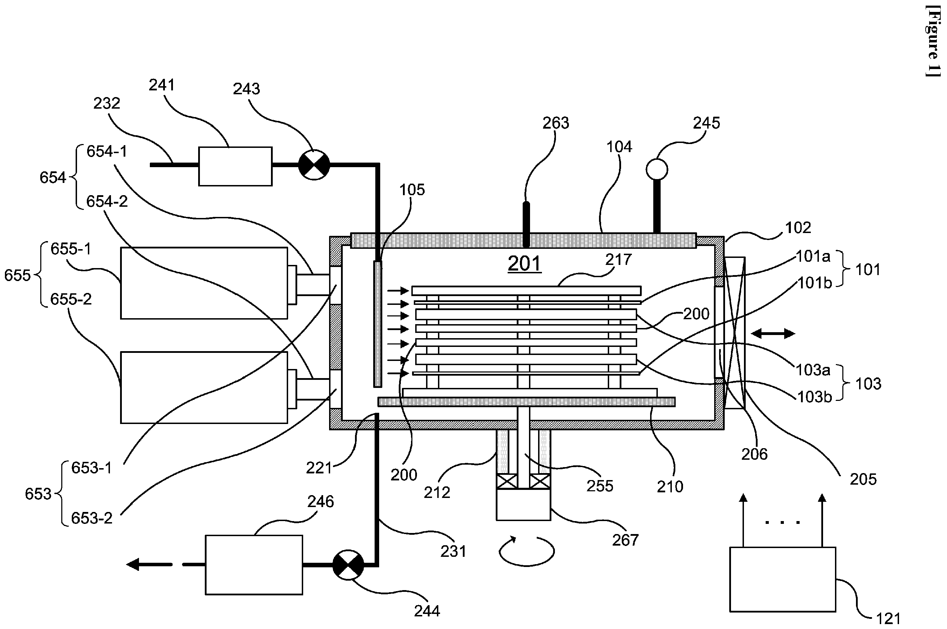

Hereinafter, one or more embodiments (also simply referred to as "embodiments") of the technique of the present disclosure will be described in detail with reference to FIGS. 1 through 11. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match.

Hereinafter, the embodiments of the technique of the present disclosure will be described in detail with reference to the drawings.

### (1) Configuration of Substrate Processing Apparatus

The present embodiments of the present disclosure will be described by way of an example in which a substrate processing apparatus 100 is configured as a single wafer type heat treatment apparatus capable of performing various kinds of heat treatments (also referred to as "heat treatment processes") on a wafer 200 or a plurality of wafers including the wafer 200. The plurality of wafers including the wafer 200 may also be simply referred to as "wafers 200". For example, in the present embodiments, the substrate processing apparatus 100 is configured as an apparatus capable of performing a modification process such as an annealing process using an electromagnetic wave described later. In the substrate processing apparatus 100 according to the present embodiments, a FOUP (Front Opening Unified Pod, hereinafter, also referred to as a "pod") 110 is used as a storage container (also referred to as a "carrier") in which the wafer 200 serving as a substrate is accommodated. The pod 110 is also used as a transfer container when the wafer 200 is transferred between various substrate processing apparatuses including the substrate processing apparatus 100.

As shown in FIGS. 1, 2 and 3, the substrate processing apparatus 100 includes: a transfer housing 202 with a transfer chamber (also referred to as a "transfer region") 203 provided therein; and cases 102-1 and 102-2 with process chambers 201-1 and 201-2 provided therein, respectively. The wafer 200 is transferred into or out of the transfer chamber 203. The cases 102-1 and 102-2 are provided on a side wall of the transfer housing 202. The cases 102-1 and 102-2 serve as a process vessel which will be described later. For example, the wafers 200 are processed in the process chambers 201-1 and 201-2, respectively. Further, a cooling case 109 constituting a cooling chamber 204 is provided between the process chambers 201-1 and 201-2.

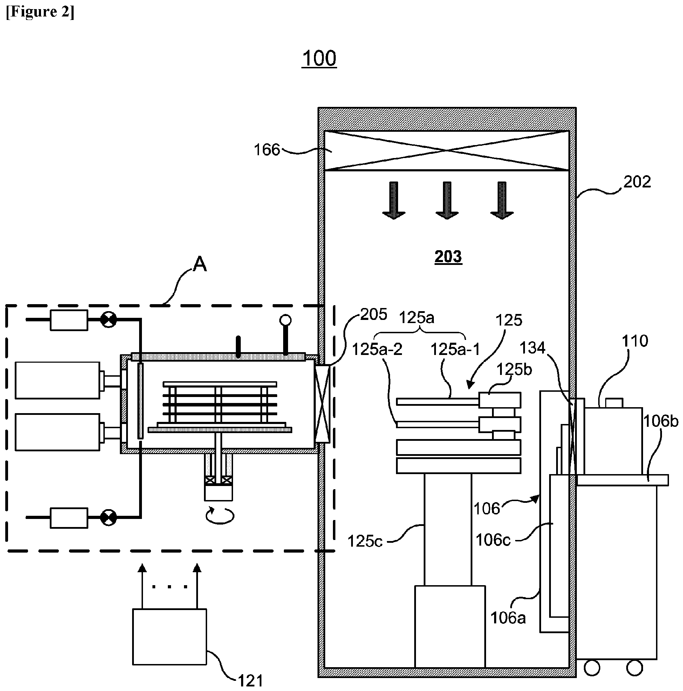

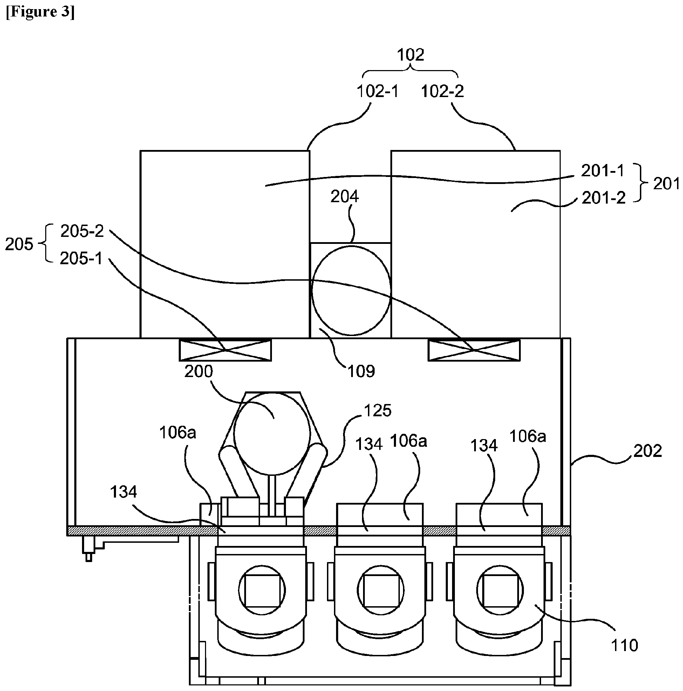

A loading port structure (also referred as an "LP") 106 serving as a pod opening/closing structure capable of opening and closing a lid (not shown) of the pod 110 so as to transfer the wafer 200 into and out of the transfer chamber 203 is provided at a front side of the transfer housing 202. That is, the loading port structure 106 is shown in a right portion of FIG. 2 (a lower portion of FIG. 3). The loading port structure 106 includes a housing 106a, a stage 106b and an opener 106c. The stage 106b is configured to transfer the pod 110 to a position close to a substrate loading/unloading port 134 provided in front of the transfer housing 202 of the transfer chamber 203 while the pod 110 is placed on the stage 106b. The opener 106c is configured to open and close the lid provided in the pod 110. The loading port structure 106 may be configured to be capable of purging an inside of the pod 110 with a purge gas such as N₂ gas. Further, the transfer housing 202 includes a purge gas circulation structure (which will be described later) capable of circulating the purge gas in the transfer chamber 203.

Gate valves 205-1 and 205-2 capable of opening and closing the process chambers 201-1 and 201-2 are provided at a rear side of the transfer housing 202, respectively. That is, the gate valves 205-1 and 205-2 are shown in a left portion of FIG. 2 (an upper portion of FIG. 3). A transfer device 125 serving as a substrate transfer structure (also referred to as a "substrate transfer robot" or a "substrate transfer device") capable of transferring the wafer 200 is provided in the transfer chamber 203. The transfer device 125 may include: a plurality of tweezers (also referred to as "arms") 125a-1 and 125a-2 serving as a placement structure on which the wafer 200 is placed; a transfer structure 125b capable of rotating or linearly moving each of the plurality of tweezers 125a-1 and 125a-2 in a horizontal direction; and a transfer structure elevator 125c capable of elevating and lowering the transfer structure 125b. By consecutive operations of the plurality of tweezers 125a-1 and 125a-2, the transfer structure 125b and the transfer structure elevator 125c, it is possible to charge (load) or discharge (unload) the wafer 200 into or out of a component such as a boat 217 (which serves as a substrate retainer or a substrate support) described later, the cooling chamber 204 and the pod 110. Hereinafter, unless they need to be distinguished separately, the cases 102-1 and 102-2 may be collectively or individually referred to as a case 102, the process chambers 201-1 and 201-2 may be collectively or individually referred to as a process chamber 201, the gate valves 205-1 and 205-2 may be collectively or individually referred to as a gate valve 205 and the plurality of tweezers 125a-1 and 125a-2 may be collectively or individually referred to as "tweezers" 125a.

The tweezers 125a-1 are made of ordinary aluminum, and are used for transferring a wafer at a low temperature or a normal temperature. The tweezers 125a-2 are made of a material (such as aluminum and quartz) whose heat resistance is high and whose thermal conductivity is low (poor), and are used to transfer a wafer at a high temperature or the normal temperature. In other words, the tweezers 125a-1 are used for transferring the wafer at the low temperature and the tweezers 125a-2 are used for transferring the wafer at the high temperature. The tweezers 125a-2 used for transferring the wafer at the high temperature are configured such that, for example, the heat resistance of the tweezers 125a-2 is preferably 100 °C or higher, more preferably 200 °C or higher. A mapping sensor (not shown) may be installed in the tweezers 125a-1 used for transferring the wafer at the low temperature. By providing the tweezers 125a-1 used for transferring the wafer at the low temperature with the mapping sensor, it is possible to check (or confirm) the number of the wafers 200 in the loading port structure 106, the number of the wafers 200 in the process chamber 201, and the number of the wafers 200 in the cooling chamber 204.

The present embodiments of the present disclosure will be described by way of an example in which the tweezers 125a-1 are used for transferring the wafer at the low temperature and the tweezers 125a-2 are used for transferring the wafer at the high temperature in the substrate processing apparatus 100. However, the present embodiments are not limited thereto. For example, the tweezers 125a-1 may be made of the material (such as aluminum and quartz) whose heat resistance is high and whose thermal conductivity is low (poor) and may be used to transfer the wafer at the high temperature or the normal temperature, and the tweezers 125a-2 may be made of ordinary aluminum and may be used for transferring the wafer at the low temperature or the normal temperature. Alternatively, both of the tweezers 125a-1 and the tweezers 125a-2 may be made of the material (such as aluminum and quartz) whose heat resistance is high and whose thermal conductivity is low (poor).

### <Process Furnace>

A process furnace (that is, the process chamber 201) provided with a substrate processing structure as shown in FIG. 1 is disposed in a region "A" surrounded by a broken line in FIG. 2. As shown in FIG. 3, although a plurality of process furnaces are provided according to the present embodiments, only one process furnace will be described and the detailed descriptions of the other process furnaces will be omitted since configurations of the plurality of process furnaces are substantially the same.

As shown in FIG. 1, the process furnace according to the present embodiments includes the case 102 serving as a cavity (process vessel) made of a material such as a metal capable of reflecting the electromagnetic wave. A cap flange (which is a closing plate) 104 made of a metal material is provided so as to close (or seal) an upper end of the case 102 via an O-ring (not shown) serving as a seal. The process chamber 201 in which the wafer 200 such as a silicon wafer is processed is mainly constituted by an inner space enclosed by the case 102 and the cap flange 104. A reaction tube (not shown) made of quartz capable of transmitting the electromagnetic wave may be provided in the case 102. When the reaction tube is provided in the case 102, the process vessel (that is, the case 102) may be configured such that the process chamber 201 is constituted by an inner space of the reaction tube. Alternatively, the process furnace may not be provided with the cap flange 104. When the cap flange 104 is not provided in the process furnace, the process chamber 201 may be defined by the case 102 with a closed ceiling.

A placement table (which is a mounting table) 210 is provided in the process chamber 201. The boat 217 serving as the substrate retainer configured to hold (support or accommodate) the wafers 200 serving as the substrates is placed on an upper surface of the placement table 210. The wafers 200 and susceptors 103a and 103b are accommodated in the boat 217. The susceptors 103a and 103b are placed with a predetermined interval therebetween to be vertically higher than and lower than the wafer 200, respectively, such that the wafers 200 are interposed therebetween. For example, a silicon plate (also referred to as a "Si plate") or a silicon carbide plate (also referred to as a "SiC plate") may be used as each of the susceptors 103a and 103b, and the susceptors 103a and 103b are arranged above and below the wafer 200 (or the wafers 200), thereby suppressing a concentration of the electric field intensity on an edge of the wafer 200. That is, the susceptors 103a and 103b suppress the absorption of the electromagnetic wave by the edge of the wafer 200. Further, quartz plates 101a and 101b serving as heat insulating plates may be placed with a predetermined interval therebetween such that the quartz plate 101a is provided above an upper surface of the susceptor 103a and the quartz plate 101b is provided below a lower surface of the susceptor 103b. According to the present embodiments, the quartz plate 101a and the quartz plate 101b are substantially identical to each other, and the susceptor 103a and the susceptor 103b are substantially identical to each other. Therefore, in the present embodiments, the quartz plate 101a and the quartz plate 101b may be collectively or individually referred to as a "quartz plate 101" unless they need to be distinguished separately. Similarly, the susceptor 103a and the susceptor 103b may be collectively or individually referred to as a "susceptor 103" unless they need to be distinguished separately.

The case 102 serving as the process vessel is a flat and sealed vessel with a horizontal cross-section of a circular shape. Further, the transfer housing 202 serving as a lower vessel is made of a metal material such as aluminum (Al) and stainless steel (SUS) or quartz. A space surrounded by the case 102 may be referred to as a "reaction region 201" or "the process chamber 201" serving as a process space, and a space surrounded by the transfer housing 202 may be referred to as the "transfer region 203" or the "transfer chamber 203" serving as a transfer space. While the process chamber 201 and the transfer chamber 203 are adjacent to each other in the horizontal direction according to the present embodiments, the present embodiments are not limited thereto. For example, the process chamber 201 and the transfer region 203 may be adjacent to each other in a vertical direction such that a substrate retainer of a predetermined structure is elevated or lowered.

As shown in FIGS. 1, 2 and 3, a substrate loading/unloading port 206 is provided at a side surface of the transfer housing 202 adjacent to the gate valve 205. The wafer 200 is moved (transferred) between the process chamber 201 and the transfer chamber 203 through the substrate loading/unloading port 206. Around the gate valve 205 or the substrate loading/unloading port 206, a choke structure whose length is 1/4 wavelength of the electromagnetic wave is provided as a countermeasure against a leakage of the electromagnetic wave as described above.

An electromagnetic wave supplier (which is an electromagnetic wave supply structure) serving as a heater described later in detail is provided at a side surface of the case 102. The electromagnetic wave such as a microwave supplied through the electromagnetic wave supplier is introduced (supplied) into the process chamber 201 to heat a component such as the wafer 200 and to process the wafer 200.

The placement table 210 is supported by a shaft 255 serving as a rotating shaft. The shaft 255 penetrates a bottom of the process chamber 201 and is connected to a driver 267 at an outside of process chamber 201. The driver (which is also referred to as a "rotator") 267 is configured to rotate the shaft 255. The wafer 200 accommodated in the boat 217 may be rotated by rotating the shaft 255 and the placement table 210 by operating the driver 267. A bellows 212 covers a lower end portion of the shaft 255 to maintain an inside of the process chamber 201 and an inside of the transfer region 203 airtight.

According to the present embodiments, the driver 267 is configured to elevate and lower the placement table 210. By operating the driver 267 based on a height of the substrate loading/unloading port 206, the placement table 210 may be elevated or lowered until the wafer 200 reaches a wafer transfer position when the wafer 200 is transferred, and the placement table 210 may be elevated or lowered until the wafer 200 reaches a processing position in the process chamber 201 (hereinafter, also referred to as a "wafer processing position") when the wafer 200 is processed.

An exhauster (which is an exhaust structure) configured to exhaust an inner atmosphere of the process chamber 201 is provided below the process chamber 201 on an outer circumference of the placement table 210. As shown in FIG. 1, an exhaust port 221 is provided in the exhauster. An exhaust pipe 231 is connected to the exhaust port 221. A pressure regulator (which is a pressure adjusting structure) 244 such as an APC (Automatic Pressure Controller) valve and a vacuum pump 246 are sequentially connected to the exhaust pipe 231 in series.

According to the present embodiments, for example, the APC valve capable of adjusting an opening degree thereof in accordance with the inner pressure of the process chamber 201 may be used as the pressure regulator 244. In the present specification, the pressure regulator 244 may also be referred to as the APC valve 244. However, in the embodiments, the pressure regulator 244 is not limited to the APC valve. The pressure regulator 244 may be embodied by a combination of a conventional opening/closing valve and a pressure regulating valve so long as it is possible to receive information on the inner pressure of the process chamber 201 (that is, a feedback signal from a pressure sensor 245 which will be described later) and to adjust an exhaust amount based on the received information.

The exhauster (also referred to as an "exhaust system" or an "exhaust line") is constituted mainly by the exhaust port 221, the exhaust pipe 231 and the pressure regulator 244. The exhauster may further include the vacuum pump 246. It is also possible to configure the exhaust port 221 to surround the placement table 210 such that a gas can be exhausted from an entire circumference of the wafer 200 through the exhaust port 221 surrounding the placement table 210.

The cap flange 104 is provided with a gas supply pipe 232 through which a process gas such as an inert gas, a source gas and a reactive gas used for performing various substrate processing is supplied into the process chamber 201. A mass flow controller (MFC) 241 serving as a flow rate controller (flow rate control structure) and a valve 243 serving as an opening/closing valve are sequentially installed at the gas supply pipe 232 in this order from an upstream side to a downstream side of the gas supply pipe 232 in a gas flow direction. For example, an inert gas supply source (not shown) is connected to the upstream side of the gas supply pipe 232 such that the inert gas can be supplied into the process chamber 201 via the MFC 241 and the valve 243. When two or more kinds of gases are used for the substrate processing, it is possible to supply the gases into the process chamber 201 by connecting one or more gas supply pipes to the gas supply pipe 232 at a downstream side of the valve 243 provided at the supply pipe 232. An MFC serving as a flow rate controller and a valve serving as an opening/closing valve may be sequentially installed at each of the one or more gas supply pipes in this order from an upstream side to a downstream side of each of the one or more gas supply pipes. Alternatively, different gas supply pipes, each provided with an MFC and a valve may be separately provided for each type of the gases.

A nozzle 105 connected to the gas supply pipe 232 is provided in the process chamber 201. A plurality of gas supply ports (not shown) through which the gas is supplied are provided on a side surface of the nozzle 105. The gas supply ports are open toward the wafer 200 such that the gas is supplied in a direction parallel to a surface of the wafer 200 through the gas supply ports. The gas supply ports are provided in a direction from a lower portion to an upper portion of the process chamber 201, that is, along a direction (that is, the vertical direction) in which the wafers 200 are accommodated (stacked) in the substrate retainer 217. The gas supply ports are provided so as to correspond to an interval of the wafers 200 (that is, an interval between every two adjacent wafers among the wafers 200) accommodated in the substrate retainer 217. An opening area of each of the gas supply ports is substantially the same, and each of the gas supply ports is provided at substantially the same opening pitch. A gas supplier (which is a gas supply system or a gas supply structure) is constituted mainly by the gas supply pipe 232, the MFC 241, the valve 243 and the nozzle 105. When the inert gas is supplied through the gas supplier, the gas supplier may also be referred to as an inert gas supplier (which is an inert gas supply system or an inert gas supply structure). For example, the N₂ gas or a rare gas such as argon (Ar) gas, helium (He) gas, neon (Ne) gas and xenon (Xe) gas may be used as the inert gas.

A temperature sensor 263 serving as a non-contact type temperature detector is provided at the cap flange 104. By adjusting an output of a microwave oscillator 655 which will be described later based on temperature information detected by the temperature sensor 263, the wafer 200 serving as the substrate is heated such that a desired temperature distribution of a temperature of the wafer 200 can be obtained. For example, the temperature sensor 263 is constituted by a radiation thermometer such as an IR (Infrared Radiation) sensor. The temperature sensor 263 is provided so as to measure a surface temperature of the quartz plate 101a or a surface temperature of the wafer 200. When the susceptor 103 (which serves as a heating structure) described above is provided, the temperature sensor 263 may be configured to measure a surface temperature of the susceptor 103. In the present embodiments, the term "temperature of the wafer 200" (or wafer temperature) may refer to a wafer temperature converted by using temperature conversion data described later (that is, an estimated wafer temperature), may refer to a temperature obtained directly by measuring the temperature of the wafer 200 by the temperature sensor 263, or may refer to both of them.

By acquiring transition data of a temperature change of the quartz plate 101 (or the susceptor 103) and the wafer 200 in advance by the temperature sensor 263, the temperature conversion data indicating a correlation between a temperature of the quartz plate 101 (or the susceptor 103) and the temperature of the wafer 200 may be stored in a memory 121c or may be stored in an external memory 123, which will be described later. By preparing the temperature conversion data in advance as described above, it is possible to estimate the temperature of the wafer 200 by measuring the temperature of the quartz plate 101 (or the susceptor 103) alone and it is also possible to control the output of the microwave oscillator 655 (that is, to control the heater) based on the estimated temperature of the wafer 200.

While the radiation thermometer is exemplified as the temperature sensor 263 serving as the temperature detector of measuring the temperature of the wafer (substrate) 200 according to the present embodiments, the present embodiments are not limited thereto. A thermocouple may be used as the temperature sensor 263 to measure the temperature of the wafer 200, or both the thermocouple and the non-contact type temperature detector (non-contact type thermometer) may be used as the temperature sensor 263 to measure the temperature of the wafer 200. However, when the thermocouple is used as the temperature sensor 263 to measure the temperature of the wafer 200, it is preferable to provide (dispose) the thermocouple in the vicinity of the wafer 200 to measure the temperature the wafer 200. That is, since it is preferable to dispose the thermocouple in the process chamber 201, the thermocouple itself may be heated by the microwave supplied from the microwave oscillator 655 described later. As a result, it is impossible to accurately measure the temperature of the wafer 200 using the thermocouple. Therefore, it is preferable to use the non-contact type thermometer as the temperature sensor 263.

While the temperature sensor 263 is provided at the cap flange 104 according to the present embodiments, the present embodiments are not limited thereto. For example, the temperature sensor 263 may be provided at the placement table 210. While the temperature sensor 263 is directly disposed at the cap flange 104 or the placement table 210 according to the present embodiments, the present embodiments are not limited thereto. For example, the temperature sensor 263 may measure the temperature of the wafer 200 indirectly by measuring the radiation reflected by a component such as a mirror and emitted through a measurement window provided in the cap flange 104 or the placement table 210. While a single temperature sensor 263 may be provided according to the present embodiments, the present embodiments are not limited thereto. A plurality of temperature sensors including the temperature sensor 263 may be provided according to the present embodiments.

Electromagnetic wave introduction ports 653-1 and 653-2 are provided at the side wall of the case 102. One end of a waveguide 654-1 and one end of a waveguide 654-2 through which the electromagnetic wave is supplied into the process chamber 201 are connected to the electromagnetic wave introduction ports 653-1 and 653-2, respectively. The other end of the waveguide 654-1 and the other end of the waveguide 654-2 are connected to microwave oscillators (hereinafter, also referred to as electromagnetic wave sources or electromagnetic wave generators) 655-1 and 655-2, respectively, serving as heating sources configured to supply the electromagnetic wave into the process chamber 201 to heat the process chamber 201. The microwave oscillators 655-1 and 655-2 are configured to supply the electromagnetic wave such as the microwave to the waveguides 654-1 and 654-2, respectively. For example, a magnetron or a klystron may be used as the microwave oscillators 655-1 and 655-2. In the present specification, unless they need to be distinguished separately, the electromagnetic wave introduction ports 653-1 and 653-2 may be collectively or individually referred to as an electromagnetic wave introduction port 653, the waveguides 654-1 and 654-2 may be collectively or individually referred to as a waveguide 654, and the microwave oscillators 655-1 and 655-2 may be collectively or individually referred to as the microwave oscillator (which is an electromagnetic wave generator) 655.

Preferably, a frequency of the electromagnetic wave generated by the microwave oscillator 655 is controlled such that the frequency is within a range from 13.56 MHz to 24.125 GHz. More preferably, the frequency is controlled to a frequency of 2.45 GHz or 5.8 GHz. In the present embodiments, the frequency of each of the microwave oscillators 655-1 and 655-2 may be the same or may be different.

While the two microwave oscillators 655-1 and 655-2 are provided on the same side surface of the case 102 according to the present embodiments, the present embodiments are not limited thereto. For example, the microwave oscillator 655 including at least one microwave oscillator may be provided according to the present embodiments. In addition, the microwave oscillator 655-1 may be provided on one side surface of the case 102 and the microwave oscillator 655-2 may be provided on another side surface of the case 102 such as a side surface facing the side surface of the case 102 at which the microwave oscillator 655-1 is provided. An electromagnetic wave supplier (which is an electromagnetic wave supply structure or an electromagnetic wave supply apparatus) serving as the heater is constituted mainly by the microwave oscillators 655-1 and 655-2, the waveguides 654-1 and 654-2 and the electromagnetic wave introduction ports 653-1 and 653-2. The electromagnetic wave supplier may also be referred to as a microwave supplier (which is a microwave supply structure or a microwave supply apparatus).

A controller 121 which will be described later is connected to each of the microwave oscillators 655-1 and 655-2. The temperature sensor 263 configured to measure the temperature of the wafer 200 or the temperature of the quartz plate 101a (or the quartz plate 101b) accommodated in the process chamber 201 is connected to the controller 121. The temperature sensor 263 is configured to measure the temperature of the quartz plate 101 or the wafer 200 as described above and to transmit the measured temperature to the controller 121. The controller 121 is configured to be capable of controlling the heating of the wafer 200 by controlling the outputs of the microwave oscillators 655-1 and 655-2. As a method of controlling the heating by the heater, for example, a method of controlling the heating of the wafer 200 by controlling a voltage input to the microwave oscillator 655, or a method of controlling the heating of the wafer 200 by changing a ratio of a turn-on time (that is, a time duration during which a power of the microwave oscillator 655 is turned on) and a turn-off time (that is, a time duration during which the power of the microwave oscillator 655 is turned off) may be used. That is, the controller 121 is configured to be capable of controlling a turn-on operation and a turn-off operation for the electromagnetic wave generated by the microwave oscillator 655.

According to the present embodiments, for example, the microwave oscillators 655-1 and 655-2 are controlled by the same control signal transmitted from the controller 121. However, the present embodiments are not limited thereto. For example, the microwave oscillator 655-1 and the microwave oscillator 655-2 may be individually controlled by individual control signals transmitted from the controller 121 to the microwave oscillator 655-1 and the microwave oscillator 655-2, respectively.

### <Controller>

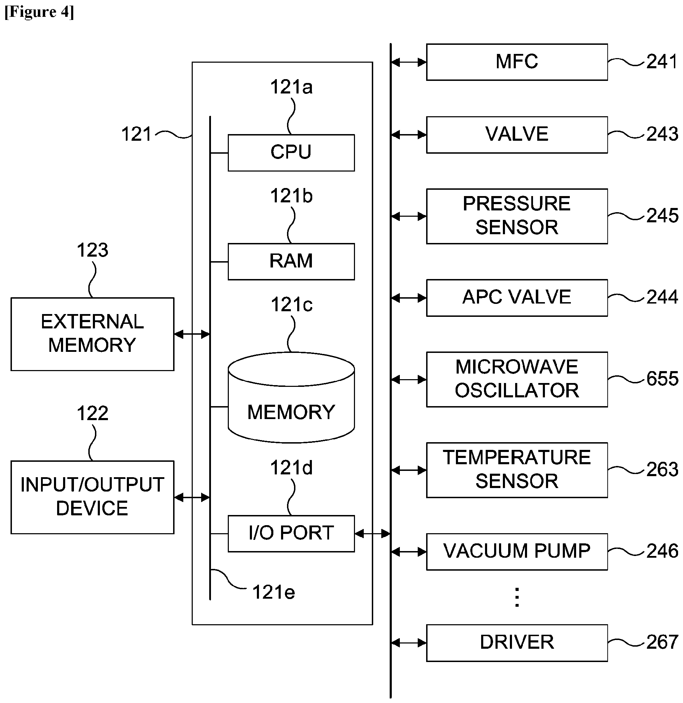

As shown in FIG. 4, the controller 121 serving as a control structure (or a control apparatus) may be constituted by a computer including a CPU (Central Processing Unit) 121a, a RAM (Random Access Memory) 121b, the memory 121c and an I/O port 121d. The RAM 121b, the memory 121c and the I/O port 121d may exchange data with the CPU 121a through an internal bus 121e. For example, an input/output device 122 constituted by a component such as a touch panel is connected to the controller 121.

For example, the memory 121c is configured by a component such as a flash memory and an HDD (Hard Disk Drive). For example, a control program configured to control operations of the substrate processing apparatus 100 and a process recipe containing information on sequences and conditions of the annealing process (modification process) of the substrate processing described later may be readably stored in the memory 121c. The process recipe is obtained by combining steps of the substrate processing described later such that the controller 121 can execute the steps to acquire a predetermined result, and functions as a program. Hereinafter, the process recipe and the control program are collectively or individually referred to as a "program". The process recipe may also be simply referred to as a "recipe". In the present specification, the term "program" may refer to the recipe alone, may refer to the control program alone, or may refer to both of the recipe and the control program. The RAM 121b functions as a memory area (work area) where a program or data read by the CPU 121a is temporarily stored.

The I/O port 121d is connected to the above-described components such as the transfer device 125, the MFC 241, the valve 243, the pressure sensor 245, the APC valve 244, the vacuum pump 246, the temperature sensor 263, the driver 267 and the microwave oscillator 655.

The CPU 121a is configured to read the control program from the memory 121c and execute the read control program. Furthermore, the CPU 121a is configured to read the recipe from the memory 121c in accordance with an operation command inputted from the input/output device 122. In accordance with the contents of the read recipe, the CPU 121a may be configured to control various operations such as a transfer operation for the substrate (that is, the wafer 200) by the transfer device 125, a flow rate adjusting operation for various gases by the MFC 241, an opening and closing operation of the valve 243, a pressure adjusting operation by the APC valve 244 based on the pressure sensor 245, a start and stop of the vacuum pump 246, an output adjusting operation by the microwave oscillator 655 based on the temperature sensor 263, an operation of adjusting rotation and rotation speed of the placement table 210 (or an operation of adjusting rotation and rotation speed of the boat 217) by the driver 267 and an elevating and lowering operation of the placement table 210 (or an elevating and lowering operation of the boat 217) by the driver 267.

The controller 121 may be embodied by installing the above-described program stored in the external memory 123 into a computer. For example, the external memory 123 may include a magnetic disk such as a hard disk, an optical disk such as a CD, a magneto-optical disk such as an MO and a semiconductor memory such as a USB memory. The memory 121c or the external memory 123 may be embodied by a non-transitory computer readable recording medium. Hereafter, the memory 121c and the external memory 123 are collectively or individually referred to as a "recording medium". In the present specification, the term "recording medium" may refer to the memory 121c alone, may refer to the external memory 123 alone, and may refer to both of the memory 121c and the external memory 123. Instead of the external memory 123, a communication structure such as the Internet and a dedicated line may be used for providing the program to the computer.

According to the present embodiments, by supplying a cooling gas through the nozzle when the substrate (that is, the wafer 200) is heated, it is possible to perform a microwave radiation for a predetermined time while maintaining the substrate at a predetermined temperature. Thereby, since temperature deviations on the substrate (wafer 200) can be suppressed by maintaining the substrate at the predetermined temperature, it is possible to suppress an occurrence of a warp or a crack of the substrate such as a semiconductor substrate. According to the present embodiments, by ejecting the gas such as the cooling gas through the nozzle so as to improve a temperature uniformity of the semiconductor substrate on a surface of the semiconductor substrate, it is possible to improve a processing quality of the semiconductor substrate (or it is possible to reduce processing defects). Further, it is possible to suppress the warp or the crack of the semiconductor substrate. In addition, since the number of substrates simultaneously processed can be increased, it is possible to sufficiently address the problems of the heat treatment process using the electromagnetic wave described above.

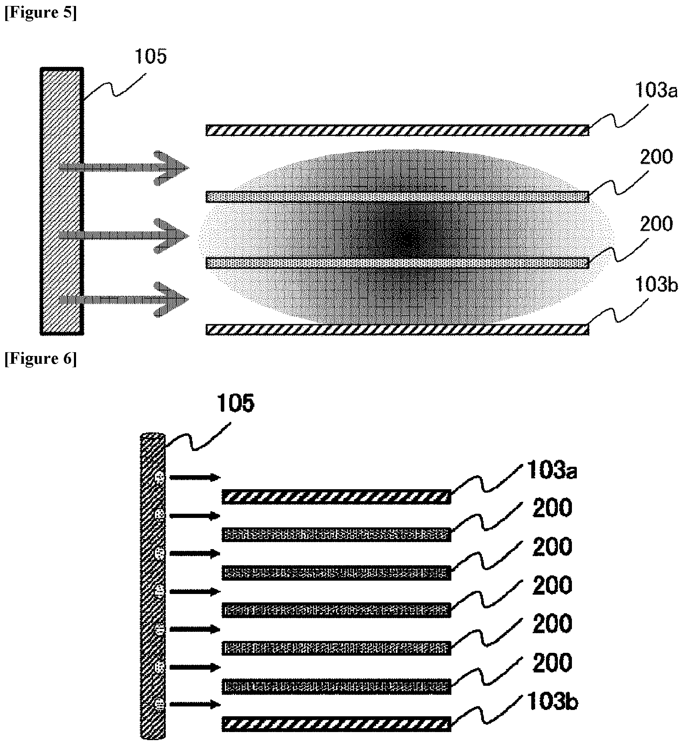

An example of conditions of a gas nozzle (that is, the nozzle 105) (which serves as a part of the gas supplier and is shown in FIG. 6) according to the present embodiments is set forth below. The gas nozzle 105 is provided in the process chamber 201 and is configured such that the gas is supplied to the wafer 200 through the gas nozzle 105.

An interval between adjacent holes: the interval between adjacent holes (that is, adjacent gas supply ports) is set to be the same as the interval between adjacent wafers.

A flow rate of the gas: the flow rate of the gas supplied to each wafer is set to be 1 slm or more and 50 slm or less.

A flow velocity of the gas: the flow velocity of the gas supplied to each wafer is set to be 0.2 m/s or more and 40.0 m/s or less.

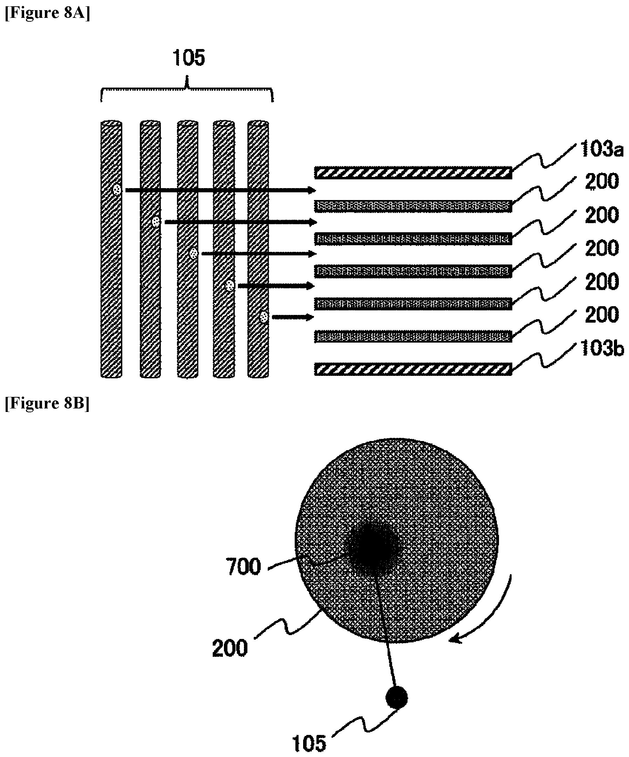

The number of holes (gas supply ports): the number of holes (that is, the gas supply ports) is set to be the same as a sum of the number of the wafers and the number of the susceptors. Specifically, when the number of the wafers is five and the number of the susceptors respectively provided above and below the wafers is two, the number of the holes is seven. Alternatively, as shown in Fig. 8A, the number of holes (that is, the gas supply ports) may also be set to be the same as the number of the wafers.

A diameter of each hole: the diameter of each hole (that is, each of the gas supply ports) is set to be Φ 0.2 mm or more and Φ 5.0 mm or less.

The smaller the diameter of each hole, the faster the flow velocity of the gas and the smaller the flow rate of the gas. In addition, it is possible to minimize the heat loss. For example, when the gas flow rate is less than 1 slm, the gas may not reach a center of the wafer 200. On the other hand, when the gas flow rate exceeds 50 slm, a supply amount of the gas becomes excessive. As a result, the cooling gas may be wasted. For example, when the gas flow velocity is less than 0.2 m/s, the gas may not reach the center of the wafer 200. On the other hand, when the gas flow velocity exceeds 40.0 m/s, the gas passing between the wafers 200 collides with a surface of a wall. As a result, the wafers 200 are adversely affected since a flow of the gas is disturbed. For example, when the diameter of each hole is less than Φ 0.2 mm, it is difficult to process each hole. On the other hand, when the diameter of each hole exceeds Φ 5.0 mm, a large amount of the gas is used to ensure a predetermined flow rate of the gas. As a result, the gas may be wasted. By performing the heat treatment process (that is, the modification process) while supplying the gas between adjacent substrates (wafers) using the nozzle, it is possible to reduce the processing defects of the substrates. In addition, it is possible to suppress the warp or the crack of the substrate, and it is also possible to increase the number of the substrates that can be simultaneously processed.

By providing the gas nozzle 105 serving as a part of the gas supplier and supplying the gas between the substrates (wafers), it is possible to improve a uniformity on the surface of the substrate (that is, the wafer 200).

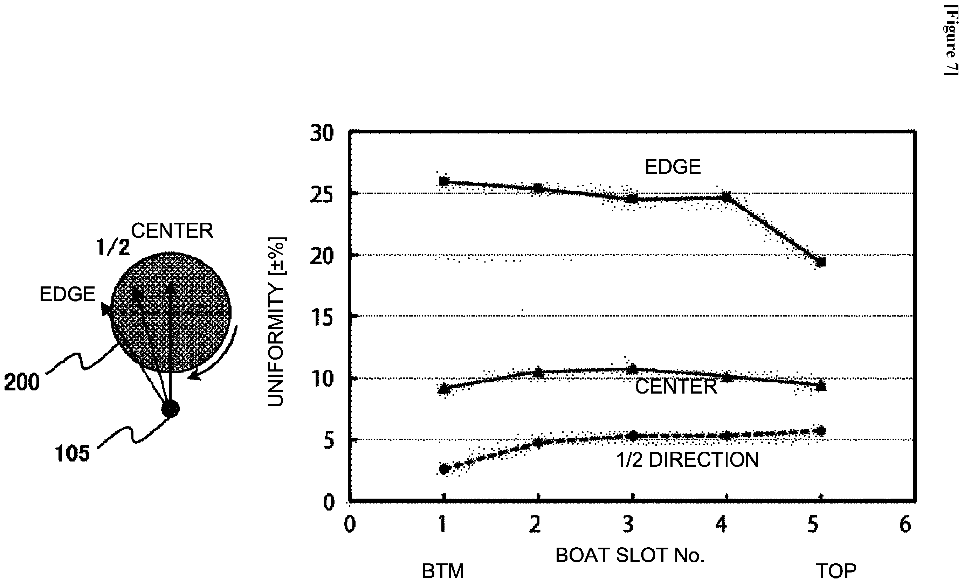

FIG. 7 is a diagram schematically illustrating a result of a change in the uniformity on the surface of the wafer 200 when an ejection direction of the gas nozzle 105 serving as a part of the gas supplier is adjusted according to the present embodiments. As shown in FIG. 7, it is possible to improve the uniformity on the surface of the wafer 200 by shifting the ejection direction of the gas nozzle 105 toward the edge of the wafer 200 away from the center of the wafer 200, for example, by adjusting the ejection direction to be directed to a halfway (1/2) position between a center and a left edge of the wafer 200. By flowing (supplying) the cooling gas between the adjacent wafers 200 to remove an excess heat build-up, it is possible to improve the uniformity on the surface of the wafer 200. As shown in FIG. 5, the heat build-up is large at the center of the wafer 200. However, when the gas nozzle 105 is directed toward the center of the wafer 200, the center of the wafer 200 alone is excessively cooled. On the other hand, since the cooling gas ejected through the gas nozzle 105 diffuses, it is possible to remove the heat build-up at the center of the wafer 200 even when the gas nozzle 105 is not directed toward the center of the wafer 200.

### <Cyclic Supply of Microwave>

When intermittently applying the microwave to the wafer 200, the gas supply is controlled to change locations (of the wafer 200 being rotated) to which the gas is supplied (in other words, supply timings are adjusted such that the gas reaches different locations of the wafer 200 at different times). By supplying the cooling gas to remove the heat build-up generated when the microwave is supplied (that is, when the microwave is tuned on) and by reducing a supply amount of the cooling gas (or by stopping a supply of the cooling gas) when the microwave is stopped (that is, when the microwave is tuned off), it is possible to prevent the wafer 200 from being excessively cooled. However, for example, in a case where the temperature of the wafer 200 is elevated rapidly or in a case where the wafer 200 is heated by applying the microwave with a high output, the cooling gas may be supplied without reducing the supply amount thereof or without stopping the supply of the cooling gas even when the microwave is turned off.

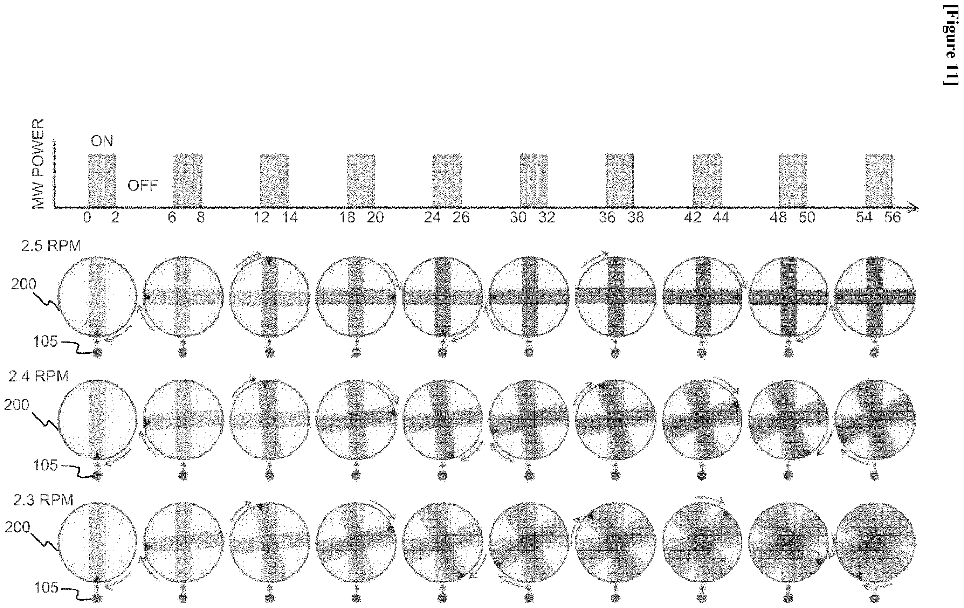

Furthermore, when a power on / off cycle of an output (power) of the microwave (that is, a cycle of the turn-on operation and the turn-off operation for the electromagnetic wave) and a rotation of the wafer 200 are not synchronized, it is possible to reduce an influence of the microwave on a temperature distribution on the surface of the wafer 200. Hereinafter, the power on / off cycle of the microwave may also be referred to as an "ON / OFF cycle" of the microwave. Specifically, the time for one rotation of the wafer 200 (which is obtained by 60 / rpm in the present case) is controlled such that the time for one rotation of the wafer 200 is not equal to an integral multiple of the cycle of the microwave (which is represented by a sum of the turn-on time and the turn-off time). FIG. 11 is a diagram schematically illustrating an example of simulation results for the number of rotations of the wafer 200 and the cycle (ON / OFF cycle) of the microwave. According to the present embodiments, for example, the microwave is turned on for 2 seconds and turned off for 4 seconds. When the rotation speed of the wafer 200 is set to 2.5 rpm, the supply of the cooling gas is repeated at specific locations of the wafer 200, so that those specific locations are cooled. That is, when the ON / OFF cycle of the microwave and the rotation of the wafer 200 are synchronized, the same locations may be cooled repeatedly. Thereby, the temperature distribution on the surface of the wafer 200 may deteriorate. On the other hand, when the rotation speed of the wafer is set to 2.4 rpm, the supply of the cooling gas will be distributed in a dispersed manner without being concentrated on the specific locations of the wafer 200. Furthermore, when the rotation speed of the wafer is set to 2.3 rpm, the supply of the cooling gas to the wafer 200 is distributed in a more dispersed manner. Thereby, it is possible to perform a cooling process on the surface of the wafer 200 more uniformly.

FIG. 8A is a diagram schematically illustrating an example in which a plurality of nozzles 105 are provided such that the flow rate of the gas can be adjusted individually for each wafer. For example, by setting the number of the nozzles 105 equal to the number of the wafers 200, it is possible to fine-tune conditions of the gas individually for each wafer. For example, the conditions of the gas to be adjusted may include the flow rate of the cooling gas and the direction of supplying the cooling gas. In such a case, for example, by measuring a temperature of an uppermost wafer among the wafers 200 at a plurality of points such as a center, an edge point and a point between the center and the edge point by using an IR (infrared) sensor, it is possible to supply the cooling gas toward a high temperature portion and it is also possible to increase the supply amount of the cooling gas to the high temperature portion. Thereby, it is possible to improve a cooling efficiency.

### <Warp Control of Substrate>

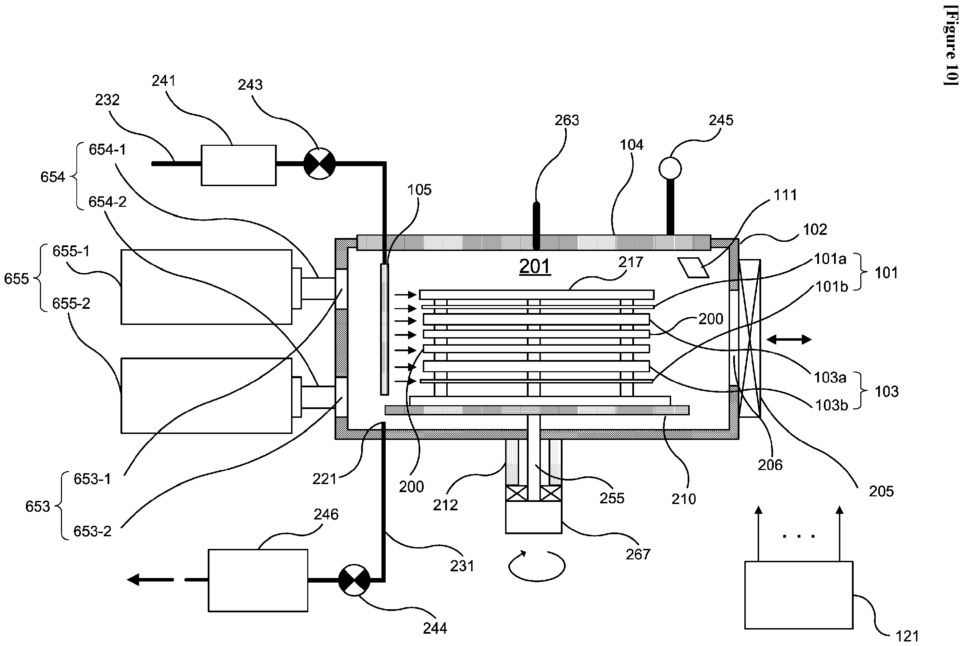

When preheating the substrate (wafer 200), by controlling the flow rate, the direction and the supply timing of the gas, it is possible to reduce a temperature difference on the surface of the substrate. Thereby, it is possible to suppress a deformation (for example, the warp). Furthermore, it is more effective when the flow of the gas is controlled by detecting the temperature difference using the IR sensor or a thermal imaging camera. When a thermal imaging camera 111 as shown in FIG. 10 is used, the thermal imaging camera 111 alone can function as a plurality of IR sensors, and it is possible to accurately measure the temperature distribution on the surface of the wafer 200. When the temperature is measured from obliquely above the wafer 200, it is possible to measure the temperature between the wafers 200. FIG. 8B is a diagram schematically illustrating a state in which the gas is directed toward a hot spot 700. Since it is possible to suppress the deformation without cooling the wafer 200, it is advantageous when the temperature is rapidly elevated.

### <Flow Rate Control Table>

For example, a type of a film of the substrate to be processed, the flow rate (or the flow velocity) of the gas, the output of the microwave and a process time are stored in advance in a table format in a storage such as the memory 121c such that the substrate processing is performed under conditions corresponding to the substrate to be processed. For example, by performing a control using a control table (that is, a table stored in advance), it is possible to cope with changes over time (or recipe steps) and changes due to the type of the film to be processed. In addition, it is possible to control an amount of the heat build-up by performing a temperature distribution measurement with the plurality of IR sensors (or the thermal imaging camera 111).

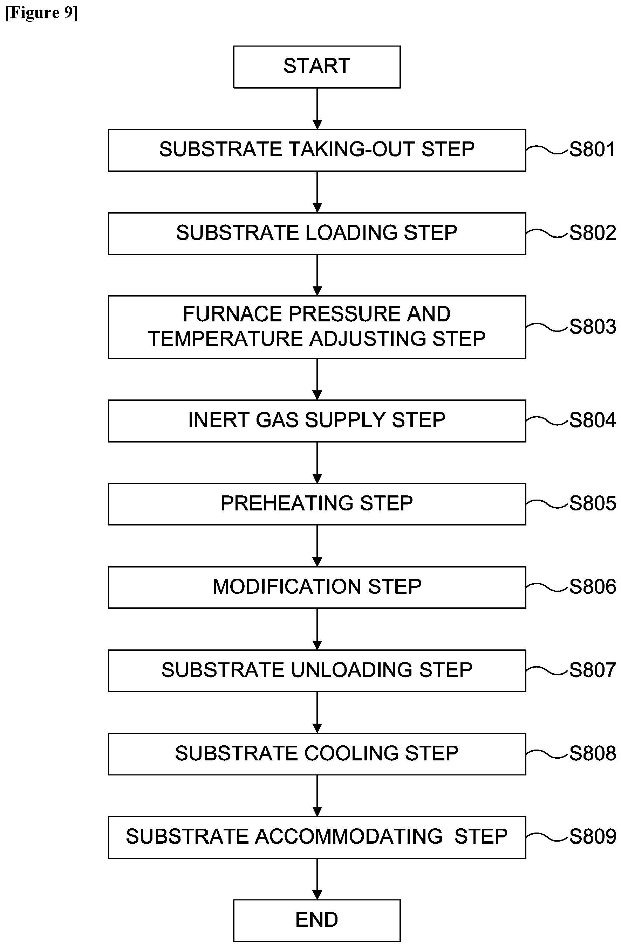

FIG. 9 is a flow chart schematically illustrating an exemplary flow of the substrate processing according to the present embodiments. Hereinafter, for example, a method of modifying (crystallizing) an amorphous silicon film serving as a silicon-containing film formed on the substrate (wafer 200), which is a part of a manufacturing process of a semiconductor device, will be described with reference to the flow chart shown in FIG. 9. The method of modifying (crystallizing) the amorphous silicon film is performed by using the substrate processing apparatus 100 described above. In the following descriptions, operations of components constituting the substrate processing apparatus 100 are controlled by the controller 121 described with reference to FIG. 4. In the present specification, the term "wafer" may refer to "a wafer itself' or may refer to "a wafer and a stacked structure (aggregated structure) of a predetermined layer (or layers) or a film (or films) formed on a surface of a wafer".

First, after a substrate taking-out step S801 is performed, a substrate loading step S802 is performed. In the substrate loading step S802, the wafers 200 are transferred (loaded) into the predetermined process chamber 201 (boat loading) while the gate valve 205 is opened by an opening and closing operation of the gate valve 205. That is, by using the tweezers 125a-1 used for transferring the wafer at the low temperature and the tweezers 125a-2 used for transferring the wafer at the high temperature, for example, five wafers are transferred (loaded) into the predetermined process chamber 201.

### <Furnace Pressure and Temperature Adjusting Step S803>

After the wafers 200 are loaded into the process chamber 201, the inner atmosphere of the process chamber 201 is controlled (adjusted) such that the inner pressure of the process chamber 201 reaches and is maintained at a predetermined pressure (for example, a pressure within a range from 10 Pa to 102,000 Pa). Specifically, the opening degree of the APC valve (the pressure regulator) 244 is feedback-controlled based on pressure information detected by the pressure sensor 245 to adjust the inner pressure of the process chamber 201 to the predetermined pressure while vacuum-exhausting the process chamber 201 by the vacuum pump 246. In the present specification, a notation of a numerical range such as "from 10 Pa to 102,000 Pa" means that a lower limit and an upper limit are included in the numerical range. Therefore, for example, the numerical range "from 10 Pa to 102,000 Pa" means a range equal to or higher than 10 Pa and equal to or lower than 102,000 Pa. The same also applies to other numerical ranges described herein.

### <Inert Gas Supply Step S804>

After the inner pressure and the inner temperature of the process chamber 201 are controlled to predetermined values by the furnace pressure and temperature adjusting step S803, the driver 267 rotates the shaft 255 and rotates the wafers 200 via the boat 217 on the placement table 210. While the driver 267 rotates the wafers 200, the inert gas such as nitrogen gas is supplied into the process chamber 201 through the gas supply pipe 232 (step S804). In the inert gas supply step S804, the inner pressure of the process chamber 201 is adjusted to a predetermined pressure. For example, the predetermined pressure of the process chamber 201 in the inert gas supply step S804 may range from 10 Pa to 102,000 Pa, for example, from 101,300 Pa to 101,650 Pa. Alternatively, the driver 267 may rotate the shaft 255 in the substrate loading step S802, that is, after the wafers 200 are loaded into the process chamber 201.

### <Preheating Step S805>

Subsequently, when the inner pressure of the process chamber 201 reaches and is maintained at a predetermined pressure, the microwave oscillator 655 supplies a first microwave into the process chamber 201 through the above-described components such as the electromagnetic wave introduction port 653 and the waveguide 654. A preheating process (that is, the preheating step S805) of heating the wafers 200 is performed by supplying the first microwave of a first output power (for example, 3,600 W) for a turn-on time (for example, 150 seconds) of a supply of the first microwave. Thereby, since the temperature of the substrate (wafer 200) can be elevated gradually, it is possible to suppress the warp or the crack of the substrate.

### <Modification Step S806>

While maintaining the inner pressure of the process chamber 201 at a predetermined pressure, the microwave oscillator 655 supplies a second microwave of a second output power (for example, 5,130 W) into the process chamber 201 for a turn-on time (for example, 600 seconds) of a supply of the second microwave through the above-described components such as the electromagnetic wave introduction port 653 and the waveguide 654. By supplying the second microwave into the process chamber 201, the wafer 200 is heated to a predetermined temperature. For example, the predetermined temperature of the wafer 200 in the modification step S806 may be within a temperature within a range from 100 °C to 1,000 °C, preferably from 400 °C to 900 °C, and more preferably from 500 °C to 700 °C. By performing the substrate processing at the temperature described above, it is possible to perform the modification step S806 of the substrate processing at the temperature at which the wafer 200 efficiently absorbs the microwave. Therefore, it is possible to improve the speed of the modification process in the modification step S806. That is, when the wafer 200 is processed at a temperature lower than 100 °C or higher than 1,000 °C, the surface of the wafer 200 may be deformed, so that the microwave is hardly absorbed on the surface of the wafer 200. This may cause difficulties in heating the wafer 200. Therefore, it is preferable to perform the modification step S806 of the substrate processing at the temperature range described above.

### <Substrate Unloading Step S807>

After returning the inner pressure of the process chamber 201 to an atmospheric pressure, the gate valve 205 is opened such that the process chamber 201 communicates with the transfer chamber 203. Thereafter, the wafers 200 (which are processed (or heated) and placed on the boat 217) are transferred (unloaded) to the transfer chamber 203 by the tweezers 125a-2 (which are used for transferring the wafer at the high temperature) of the transfer device 125 (step S807).

### <Substrate Cooling Step S808>

The wafers 200 (which are heated (processed) and transferred by the tweezers 125a-2 used for transferring the wafer at the high temperature) are moved to the cooling chamber 204 by consecutive operations of the transfer structure 125b and the transfer structure elevator 125c. For example, five wafers 200 are placed in the cooling chamber 204 by the tweezers 125a-2 used for transferring the wafer at the high temperature. By placing the wafer 200 in the cooling chamber 204 for a predetermined time, it is possible to cool the wafers 200 (step S808).

### <Substrate Accommodating Step S809>

The wafers 200 cooled by performing the substrate cooling step S808 are taken out from the cooling chamber 204, and then are transferred to a predetermined pod.

For example, the present embodiments are described by way of an example in which the first output power (also referred to as a "first output") of the first microwave is set to 3,600 W. However, the present embodiments are not limited thereto. For example, the first output may be within a range from 2,000 W to 4,000 W. When setting the first output to be within the range from 2,000 W to 4,000 W, it is advantageous to shorten a time taken from a time when the warp of the wafer 200 starts to a time when the warp reaches its maximum and becomes saturated there. When setting the first output to be lower than 2,000 W, it is disadvantageous in that it may take too long before the temperature of the wafer 200 starts elevating. Further, when setting the first output to be higher than 4,000 W, it is disadvantageous in that the temperature of the wafer 200 may be elevated rapidly and the warp of the wafer 200 may become excessive, which may bring the wafer 200 into contact with other components.

For example, the present embodiments are described by way of an example in which the output power (also referred to as a "second output") of the second microwave is set to 5,130 W. However, the present embodiments are not limited thereto. For example, the second output may be within a range from 4,000 W to 12,000 W. When setting the second output to be within the range from 4,000 W to 12,000 W, it is advantageous in that the temperature of the wafer 200 can be adjusted to a proper temperature for performing the modification process. When setting the second output to be lower than 4,000 W, it is disadvantageous in that it may take a long time to perform the modification process or the modification process may not be performed sufficiently. Further, when setting the second output to be higher than 12,000 W, it is disadvantageous in that, depending on the number of the wafers 200 processed at one time (that is, simultaneously), an electrical discharge or a plasma may occur when a limit of a microwave absorption by the wafers 200 is exceeded.

According to the present embodiments described above, by supplying the gas through the nozzle 105 when the substrate (that is, the wafer 200) is heated such that the temperature distribution on the surface of the semiconductor substrate (that is, the wafer 200) can be uniformized, it is possible to perform the modification process by supplying the gas to the substrate for a predetermined time while maintaining the substrate at a predetermined temperature. Thereby, it is possible to reduce the temperature difference on the semiconductor substrate. As a result, it is possible to improve the processing quality of the semiconductor substrate, and it is also possible to suppress the occurrence of the warp or the crack of the semiconductor substrate. In addition, it is possible to simultaneously process a plurality of substrates, and it is also possible to improve a productivity.

### <Other Embodiments of Present Disclosure>

The embodiments described above may be appropriately modified, and it is also possible to obtain substantially the same effects when the present embodiments are appropriately modified. For example, the present embodiments are described by way of an example in which the amorphous silicon film serving as the film containing silicon as a primary element (main element) is modified into a polysilicon film by performing the modification process. However, the technique of the present disclosure is not limited thereto. For example, the technique of the present disclosure may be applied to modify a film formed on the surface of the wafer 200 by supplying a gas containing at least one selected from the group consisting of oxygen (O), nitrogen (N), carbon (C) and hydrogen (H). For example, when a hafnium oxide film (HfₓO_{y} film) serving as a high dielectric film is formed on the wafer 200, a deficient oxygen in the hafnium oxide film can be supplemented and the characteristics of the high dielectric film can be improved by supplying the microwave to heat the wafer 200 while supplying a gas containing oxygen.

While the hafnium oxide film is mentioned above as an example, the technique of the present disclosure is not limited thereto. For example, the technique of the present disclosure may be applied to modify a metal-based oxide film, that is, an oxide film containing at least one metal element such as aluminum (Al), titanium (Ti), zirconium (Zr), tantalum (Ta), niobium (Nb), lanthanum (La), cerium (Ce), yttrium (Y), barium (Ba), strontium (Sr), calcium (Ca), lead (Pb), molybdenum (Mo) and tungsten (W). That is, the substrate processing described above may be preferably applied to modify a film formed on the wafer 200 such as a TiOCN film, a TiOC film, a TiON film, a TiO film, a ZrOCN film, a ZrOC film, a ZrON film, a ZrO film, a HfOCN film, a HfOC film, a HfON film, a HfO film, a TaOCN film, a TaOC film, a TaON film, a TaO film, a NbOCN film, a NbOC film, a NbON film, a NbO film, an AlOCN film, an AlOC film, an AlON film, an AlO film, a MoOCN film, a MoOC film, a MoON film, a MoO film, a WOCN film, a WOC film, a WON film and a WO film.

Without being limited to the high dielectric film, it is also possible to heat a film containing silicon as a main element and doped with impurities. A silicon-based film such as a silicon nitride film (SiN film), a silicon oxide film (SiO film), a silicon oxycarbide film (SiOC film), a silicon oxycarbonitride film (SiOCN film) and a silicon oxynitride film (SiON film) may be used as the above-mentioned film containing silicon as the main element. For example, the impurities may include at least one metal element such as boron (B), carbon (C), nitrogen (N), aluminum (Al), phosphorus (P), gallium (Ga) and arsenic (As).

In addition, the technique of the present disclosure may be applied to modify a photoresist film based on at least one photoresist among methyl methacrylate resin (polymethyl methacrylate, PMMA), epoxy resin, novolac resin or polyvinyl phenyl resin.

The invention may be summarized as follows: According to the present disclosure, there is provided a technique capable of preventing a substrate from being warped or cracked due to a heat treatment process. According to one aspect thereof, there is provided a substrate processing apparatus including: a process chamber in which a plurality of substrates accommodated in a substrate retainer are processed; an electromagnetic wave generator configured to supply an electromagnetic wave into the process chamber; and a gas supplier configured to supply a cooling gas is supplied to between adjacent substrates among the plurality of substrates via a plurality of gas supply ports provided so as to correspond to an interval of the plurality of substrates accommodated in the substrate retainer.

While the present embodiments are described by way of an example in which the substrate processing is performed as a part of the manufacturing process of the semiconductor device, the technique of the present disclosure is not limited thereto. For example, the technique of the present disclosure may be applied to other substrate processing such as a patterning process of a manufacturing process of a liquid crystal panel, a patterning process of a manufacturing process of a solar cell and a patterning process of a manufacturing process of a power device.

Further, the technique of the present disclosure is not limited to the embodiments described above, and the technique of the present disclosure may be applied to various modified examples of the embodiments described above. For example, the embodiments described above are described in detail in order to explain the technique of the present disclosure in an easy-to-understand manner. That is, the technique of the present disclosure is not limited to those including the entire configurations of the embodiments described above.

For example, the embodiments described above are mainly described by way of an example in which the program for implementing an entirety of or a part of configurations or functions of the controller serving as the control structure is provided. However, for example, an entirety of or a part of functions of a processor serving as the controller may be implemented by a hardware by designing an integrated circuit to be used instead of the program. That is, an entirety of or a part of the functions of the processor may be implemented by using the integrated circuit such as an ASIC (Application Specific Integrated Circuit) and an FPGA (Field Programmable Gate Array) instead of the program.

### [Description of Reference Numerals]

100: substrate processing apparatus
105: nozzle (gas nozzle)
200: wafer (substrate, semiconductor substrate)
655: microwave oscillator (electromagnetic wave source, electromagnetic wave generator)

## Claims

1. A substrate processing apparatus comprising:
a process chamber in which a plurality of substrates accommodated in a substrate retainer are processed;
an electromagnetic wave generator configured to supply an electromagnetic wave into the process chamber; and
a gas supplier configured to supply a cooling gas to between adjacent substrates among the plurality of substrates via a plurality of gas supply ports provided so as to correspond to an interval of the plurality of substrates accommodated in the substrate retainer.

2. The substrate processing apparatus of claim 1, wherein the number of the plurality of gas supply ports is set to be equal to the number of the plurality of substrates.

3. The substrate processing apparatus of claim 1 and/or 2, wherein the plurality of gas supply ports are open such that the cooling gas is capable of being supplied through the plurality of gas supply ports in a direction directed to a position deviated from a center toward an edge of each of the plurality of substrates.

4. The substrate processing apparatus of any one or more of claims 1 to 3, wherein a flow velocity of the cooling gas is set to be 0.2 m/s or more and 40.0 m/s or less.

5. The substrate processing apparatus of any one or more of claims 1 to 4, wherein a flow rate of the cooling gas is set to be 1 slm or more and 50 slm or less.

6. The substrate processing apparatus of any one or more of claims 1 to 5, wherein a diameter of each of the plurality of gas supply ports is set to be 0.2 mm or more and 5.0 mm or less.

7. The substrate processing apparatus of any one or more of claims 1 to 6, further comprising
a controller configured to be capable of controlling a turn-on operation and a turn-off operation for the electromagnetic wave generated by the electromagnetic wave generator.

8. The substrate processing apparatus of claim 7, further comprising
a rotator configured to rotate the plurality of substrates accommodated in the substrate retainer,
wherein the controller is further configured to be capable of controlling the rotator.

9. The substrate processing apparatus of claim 8, wherein the controller is further configured to be capable of controlling the electromagnetic wave generator and the rotator such that a cycle of the turn-on operation and the turn-off operation for the electromagnetic wave is asynchronous with a rotation of the plurality of substrates.

10. The substrate processing apparatus of any one or more of claims 1 to 9, wherein the electromagnetic wave generator is provided on a side wall of the process chamber.

11. The substrate processing apparatus of any one or more of claims 1 to 10, wherein the electromagnetic wave comprises a microwave.

12. The substrate processing apparatus of any one or more of claims 1 to 11, wherein the plurality of gas supply ports are provided along a direction in which the plurality of substrates are accommodated in the substrate retainer.

13. A method of manufacturing a semiconductor device, comprising:
(a) loading a plurality of substrates into a process chamber of a substrate processing apparatus, wherein the substrate processing apparatus comprises:
the process chamber in which the plurality of substrates accommodated in a substrate retainer are processed;
an electromagnetic wave generator configured to supply an electromagnetic wave into the process chamber; and
a gas supplier configured to supply a cooling gas to between adjacent wafers among the plurality of substrates through a plurality of gas supply ports provided so as to correspond to an interval of the plurality of substrates accommodated in the substrate retainer; and
(b) processing the plurality of substrates.

14. The method of claim 13, wherein, in (b), the cooling gas is supplied in a direction directed to a position deviated from a center toward an edge of each of the plurality of substrates.

15. A program that causes a substrate processing apparatus, by a computer, to perform:
(a) loading a plurality of substrates into a process chamber of the substrate processing apparatus, wherein the substrate processing apparatus comprises:
the process chamber in which the plurality of substrates accommodated in a substrate retainer are processed;
an electromagnetic wave generator configured to supply an electromagnetic wave into the process chamber; and
a gas supplier configured to supply a cooling gas to between adjacent wafers among the plurality of substrates through a plurality of gas supply ports provided so as to correspond to an interval of the plurality of substrates accommodated in the substrate retainer; and
(b) processing the plurality of substrates.
